# EUROPÄISCHE PATENTSCHRIFT

(11) **EP 3 553 827 B1**
(45) Veröffentlichungstag und Bekanntmachung des Hinweises auf die Patenterteilung: **22.07.2020**
(21) Anmeldenummer: 19000163.6
(22) Anmeldetag: 01.04.2019
(51) Int. Cl.: H01L 29/861, H01L 29/20, H01L 29/06, H01L 21/329, H01L 29/32, H01L 29/34, H01L 29/36, H01L 21/18

(54) **STAPELFÖRMIGES III-V-HALBLEITERBAUELEMENT**
STACKED III-V SEMI-CONDUCTOR DEVICE
COMPOSANT À SEMI-CONDUCTEUR III-V SOUS FORME D'EMPILEMENT

(30) Priorität: 09.04.2018 DE 102018002895
(43) Veröffentlichungstag der Anmeldung: 16.10.2019
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- US-A- 5 213 994
- US-A1- 2006 281 263
- US-A1- 2017 069 714
- A. KOEL: "Characterization of the temperature dependent behavior of snappy phenomenon by the switching-off of GaAs power diode structures", ADVANCES IN FLUID MECHANICS XI, Bd. 1, 1. Juli 2014 (2014-07-01), Seiten 439-449, XP055545469, Southampton UK ISSN: 1746-4471, DOI: 10.2495/HT140381 ISBN: 978-1-78466-105-2
- VIKTOR VOITOVICH ET AL: "LPE technology for power GaAs diode structures", ESTONIAN JOURNAL OF ENGINEERING, Bd. 16, Nr. 1, 1. Januar 2010 (2010-01-01) , Seiten 11-22, XP055498749, DOI: 10.3176/eng.2010.1.04

## Beschreibung

Die Erfindung betrifft ein stapelförmiges III-V-Halbleiterbauelement.

Aus Josef Lutz et al, Semiconductor Power Devices, Springer Verlag, 2011, ISBN 978-3-642-11124-2, sind hochsperrende Schottky-Dioden sowie IGBTs auf Basis von Silizium oder SiC bekannt.

Aus "GaAs Power Devices" von German Ashkinazi, ISBN 965-7094-19-4, sind hochspannungsfeste Halbleiterdioden p+ - n - n+ sowie Schottky-Dioden, hochspannungsfeste p-n-i-p Transistoren auf GaAs Basis bekannt. In Kapitel 5.3 wird außerdem ein Mesa Prozess sowie das Beschichten von Seitenflächen mit einem Polyimid beschrieben.

Aus A.Koel: "Characterization of the temperature dependent behavior of snappy phenomenon by the switching-off of GaAs power diode structures", Adavances in Fluid Mechanics XI, Bd. 1, 1. Juli 2014, Seiten 439-449, XP 055545469, Southampton UK ISSN: 1746-4471, ISBN: 978-1-78466-105-2 ist eine GaAs Power Diode bekannt, welche ein p⁺-Substrat, eine p-Schicht, eine n⁻⁻-Schicht, eine n⁻-Schicht und eine n⁺-Schicht aufeinander folgend aufweist. Die Seitenfläche der Diode weist eine abgerundete umlaufende Aussparung auf, die sich von der n⁺-Schicht bis zum Substrat erstreckt.

Vor diesem Hintergrund besteht die Aufgabe der Erfindung darin, eine Vorrichtung anzugeben, die den Stand der Technik weiterbildet.

Die Aufgabe wird durch ein stapelförmiges III-V-Halbleiterbauelement mit den Merkmalen des Patentanspruchs 1 gelöst. Vorteilhafte Ausgestaltungen der Erfindung sind Gegenstand von Unteransprüchen.

Die Oberseite und Unterseite des Stapels sind beispielsweise rechteckig, quadratisch oder rund ausgebildet. Als Seitenfläche werden alle die Unterseite mit der Oberseite verbindenden Flächenabschnitte bezeichnet, die den Stapel seitlich umschließen. Durch die absatzförmigen Ränder ist die Seitenfläche stufenförmig ausgebildet.

Es sei angemerkt, dass die Schichten bevorzugt mittels einer Flüssigphasenepitaxie oder mittels einer MOVPE Anlage hergestellt werden.

Es versteht sich, dass das das Halbleiterbauelement mindestens zwei bevorzugt als Schichten ausgebildete Anschlusskontakte aufweist, wobei die Anschlusskontakte jeweils elektrisch leitfähig sind und metallische Eigenschaften aufweisen.

Bevorzugt bestehen die Anschlusskontaktschichten aus metallisch leitfähigen Halbleiterschichten oder Metallschichten oder einer Kombination aus beiden. Die Anschlusskontakte stellen einen elektrisch niederohmigen Kontakt zu den unmittelbar angrenzenden dotierten Halbleiterschichten her. Des Weiteren versteht es sich, dass die Anschlusskontakte vorzugsweise mittels Bonddrähte mit Kontaktfinger, den sogenannten Pins, verschaltet sind.

Die Anschlusskontakte sind bevorzugt auf einer Oberseite bzw. einer Unterseite des aus den Halbleiterbereichen bzw. Halbleiterschichten gebildeten Stapels angeordnet.

Die umlaufenden absatzförmigen Ränder sind jeweils mittels eines Ätzprozesses hergestellt. Die Tiefe der Stufen, also der Abstand zwischen der Oberseite des Stapels und dem ersten Rand bzw. zwischen dem ersten Rand und dem zweiten Rand, wird bevorzugt über eine jeweilige Ätzzeit in Abhängigkeit von der Ätzrate kontrolliert.

Ein Vorteil Ist, dass sich mit der Strukturierung des Randes sich die Bauelementeigenschaften verbessern lassen. Insbesondere lassen sich die Sperrspannungen erhöhen und die Leckströme an der Oberfläche unterdrücken.

Anders ausgedrückt lassen sich mit der erfindungsgemäßen III-V-Halbleiterdiode auf einfache Weise niedrige Leckströme bei Sperrspannungen in einem Bereich von 200V - 3000 V mit kleineren Einschaltwiderständen und geringeren Kapazitäten pro Fläche als herkömmliche hochsperrende Dioden aus Si oder aus SiC herstellen.

Hierdurch sind Schaltfrequenzen von 30 kHz bis zu 0,5 GHz und Stromdichten von 0,5 A/mm² bis 5 A/mm² erreichbar.

Ein anderer Vorteil ist, dass sich die III-V-Halbleiterdioden kostengünstiger als vergleichbare hochsperrende Dioden aus SiC herstellen lassen.

Insbesondere lassen sich die erfindungsgemäßen III-V-Halbleiterdioden als Freilaufdioden verwenden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten. Hierbei sind niedrige Leckströme aufgrund des exponentiellen Anstiegs mit steigender Temperatur besonders hilfreich.

In einer Weiterbildung ist zumindest entlang eines Teils der Seitenflächen des Stapels in dem Stapel eine durch Implantation erzeugte erste Isolationsschicht ausgebildet. Die Isolationsschicht ist beispielsweise als amorphisierter Randbereich ausgebildet, wobei die Amorphisierung beispielsweise durch Implantation von Wasserstoff-Ionen erreicht wird.

Gemäß einer weiteren Weiterbildung erstreckt sich zumindest entlang eines Teils der Seitenfläche des Stapels eine Isolationsschicht. Beispielsweise wird mittels chemischer Gasphasenabscheidung (chemical vapor desposition, CVD) eine Oxidschicht auf die Seitenfläche aufgebracht. Die Oxidschicht weist bevorzugt eine Dicke von 10 µm -15 µm oder von 20 µm - 30 µm auf.

In einer anderen Ausführungsform umfasst das Halbleiterbauelement eine erste Kontaktschicht und eine zweite Kontaktschicht, wobei die zweite Kontaktschicht die Oberseite des Stapels teilweise überdeckt, so dass die Oberseite des Stapels einen dritten umlaufenden Rand mit einer Breite von mindestens 10 µm um die zweite Kontaktschicht herum ausbildet. Die erste Kontaktschicht überdeckt die Unterseite des Stapels bevorzugt vollständig.

Gemäß einer anderen Ausführungsform sind der p⁺-Bereich und der n⁺-Bereich schichtförmig ausgebildet, wobei der schichtförmige n⁺-Bereich und der schichtförmige p⁺-Bereich jeweils stoffschlüssig mit der n⁻-Schicht verbunden sind, der schichtförmige n⁺-Bereich eine Schichtdicke von 50 - 675 µm aufweist, der schichtförmige p⁺-Bereich eine Schichtdicke größer 2 µm aufweist, das stapelförmige III-V-Halbleiterbauelement eine erste Defektschicht mit einer Schichtdicke zwischen 0,5 µm und 50 µm aufweist und die Defektschicht innerhalb der n⁻-Schicht angeordnet ist und eine Defektkonzentration in einem Bereich zwischen 1•10¹³ N/cm³ und 5•10¹⁶ N/cm³ aufweist.

Es versteht sich, dass sich die Defektschicht auf unterschiedliche Weise, beispielsweise durch Implantation oder mittels Einbau von Fremdatomen erzeugen lässt und innerhalb der Defektschicht eine Rekombination von Ladungsträger erreicht wird. Vorzugsweise werden die Defekte bzw. die Rekombinationszentren durch Einbau von Chrom erreicht.

Gemäß einer Weiterbildung beträgt eine Schichtdicke der Defektsicht ein Abstand der Defektschicht zu einer Grenzfläche zwischen der n⁻-Schicht und der p⁺-Bereich höchstens die Hälfte der Schichtdicke der n⁻-Schicht.

Es sei angemerkt, dass die Defektschicht vorzugsweise nicht innerhalb der Raumladungszone ausgebildet ist. Vorzugsweise ist die Dicke der n⁻-Schicht derart ausgebildet, dass die Defektschicht von der Raumladungszone beabstandet ist.

In einer weiteren Ausführungsform sind der p⁺-Bereich und der n⁺-Bereich schichtförmig ausgebildet, wobei der schichtförmige n⁺-Bereich stoffschlüssig mit der n⁻-Schicht verbunden ist, zwischen der n⁻-Schicht und der p⁺-Schicht eine dotierte Zwischenschicht mit einer Schichtdicke von 1-50 µm und einer Dotierstoffkonzentration von 10¹²-10¹⁷ cm⁻³ angeordnet ist und die Zwischenschicht mit der n⁻-Schicht und mit der p⁺-Schicht stoffschlüssig verbunden ist.

Es versteht sich, dass die Zwischenschicht eine im Vergleich zu den stoffschlüssig verbundenen Schichten wenigstens eine unterschiedliche Dotierstoffkonzentration aufweist.

Bevorzugt ist die Zwischenschicht p-dotiert und umfasst besonders bevorzugt Zink oder Kohlenstoff als Dotierstoffe. Die Dotierstoffkonzentration der p-dotierten Zwischenschicht ist besonders bevorzugt kleiner als die Dotierstoffkonzentration des p⁺-Bereichs, insbesondere um einen Faktor 2 bis zu einem Faktor von 5 Größenordnungen.

Alternativ ist die Zwischenschicht n-dotiert und umfasst bevorzugt Silizium und/oder Zinn, wobei die Dotierstoffkonzentration der n-dotierten Zwischenschicht besonders bevorzugt um bis zu einem Faktor 100 kleiner als die Dotierstoffkonzentration des n⁻-Bereichs ist.

In einer Weiterbildung ist die III-V-Halbleiterdiode monolithisch ausgebildet, d.h. die einzelnen monolithisch ausgebildeten Schichten sind zueinander ebenfalls monolithisch ausgebildet.

In einer anderen Ausführungsform umfasst die III-V Halbleiterdiode wenigstens einen Halbleiterbond.

Es wird angemerkt, dass der Ausdruck Halbleiterbond synonym mit dem Ausdruck Waferbond verwendet wird.

In einer weiteren Ausführungsform ist der Halbleiterbond bei dem stapelförmigen Schichtaufbau, bestehend aus dem p⁺-Schicht, der p-dotierten Zwischenschicht, der n⁻-Schicht und der n⁺-Schicht, zwischen der n⁻-Schicht und der p-dotierten Zwischenschicht ausgebildet.

In einer Ausführungsform bildet der Schichtaufbau bestehend aus einem p⁺-Schicht und der p-dotierten Zwischenschicht einen ersten Teilstapel und der Schichtaufbau bestehend aus der n⁺-Schicht und der n⁻-Schicht einen zweiten Teilstapel.

In einer Weiterbildung wird der erste Teilstapel gebildet, in dem ausgehend von einem p⁺-Schicht mittels Epitaxie die p-dotierten Zwischenschicht hergestellt wird.

Vorzugsweise weist die als p⁻-Schicht ausgebildete Zwischenschicht eine Dotierung kleiner als 10¹³ N/cm³ oder eine Dotierung zwischen 10¹³ N/cm³ und 10¹⁵ N/cm³ auf. In einer Ausführungsform wird das p⁺-Schicht vor oder nach dem Bonden durch einen Schleifprozess auf eine Dicke zwischen 200 µm und 500 µm gedünnt.

In einer Weiterbildung sind der erste Teilstapel und der zweite Teilstapel jeweils monolithisch ausgebildet.

In einer Ausführungsform wird der zweite Stapel gebildet, in dem ausgehend von einem n⁻-Substrat, das n⁻-Substrat mit dem zweiten Stapel durch einen weiteren Waferbondprozess verbunden wird.

In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm. Vorzugsweise liegt die Dotierung des n⁻-Substrats in einem Bereich zwischen 10¹³ N/cm³ und 10¹⁵ N/cm³.

Ein Vorteil des Waferbondens ist es, dass sich dicke n⁻-Schichten ohne weiteres herstellen lassen. Ein langer Abscheideprozess bei der Epitaxie entfällt hierdurch. Auch lassen sich mittels des Bondens die Anzahl der Stapelfehler bei den dicken n⁻-Schichten verringern.

In einer anderen Weiterbildung wird vor dem Bonden die Defektschicht vorzugsweise mittels Implantation von Ionen in die Oberfläche des ersten Teilstapels, d.h. in die p-dotierten Zwischenschicht erzeugt.

In eine alternativen Ausführungsform weist das n⁻-Substrat eine Dotierung größer als 10¹⁰ N/cm⁻³ und kleiner als 10¹³ N/cm⁻³ auf. In dem die Dotierung extrem gering ist, lässt sich das n⁻-Substrat auch als eine intrinsische Schicht auffassen.

In einer Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm³ und kleiner als 5x10¹⁹ N/cm³ erzeugt.

Es versteht sich, dass das Dünnen des n⁻-Substrats vorzugsweise mittels eines CMP Schrittes, d.h. mittels chemischen mechanischen Polierens erfolgt.

In einer anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Hilfsschicht von der Vorderseite abgelöst.

In einer Ausführungsform werden die Oberfläche des n⁺-Substrats und die Oberfläche der p⁺-Schicht metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p⁺-Schicht ausgebildet.

Untersuchungen haben gezeigt, dass sich mit bestimmten Kombinationen von einer p⁻- Zwischenschicht und n⁻-Schicht verschiedene Sperrspannungen erzielen lassen.

In einer ersten Variante umfasst die:
p⁻- Zwischenschicht eine Dicke zwischen 10 µm bis 25 µm und für die n⁻-Schicht eine Dicke zwischen 40 µm und 90 µm eine Sperrspannung von ca. 900 V ergibt.

In einer zweiten Variante umfasst die:
p⁻- Zwischenschicht eine Dicke zwischen 25 µm bis 35 µm und für die n⁻-Schicht eine Dicke zwischen 40 µm und 70 µm eine Sperrspannung von ca. 1200 V ergibt.

In einer dritten Variante umfasst die:
p⁻- Zwischenschicht eine Dicke zwischen 35 µm bis 50 µm und für die n⁻-Schicht eine Dicke zwischen 70µm und 150 µm und 70 µm eine Sperrspannung von ca. 1500 V ergibt.

Die Dioden in der ersten bis dritten Variante lassen sich auch als Punsch- Dioden bezeichnen.

In einer vierten Variante umfasst die:
p⁻- Zwischenschicht eine Dicke zwischen 10 µm bis 25 µm und für die n⁻-Schicht eine Dicke zwischen 60 µm und 110 µm.

In einer fünften Variante umfasst die:
p⁻- Zwischenschicht eine Dicke zwischen 10 µm bis 25 µm und für die n⁻-Schicht eine Dicke zwischen 70 µm und 140.

In einer sechsten Variante umfasst die:
p⁻- Zwischenschicht eine Dicke zwischen 35 µm bis 50 µm und für die n⁻-Schicht eine Dicke zwischen 80µm und 200 µm.

Die Dioden in der vierten bis sechsten Variante lassen sich auch als "non - reach - through" - Dioden bezeichnen.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine schematische Ansicht auf eine erste erfindungsgemäße Ausführungsform eines Halbleiterbauelements,
- Figur 2: eine schematische Schnittansicht der Schichtenfolge einer erfindungsgemäße Ausführungsform eines Halbleiterbauelements,
- Figur 3: eine schematisch Schnittansicht der Schichtfolgen einer zweiten erfindungsgemäßen Ausführungsform eines Halbleiterbauelements.

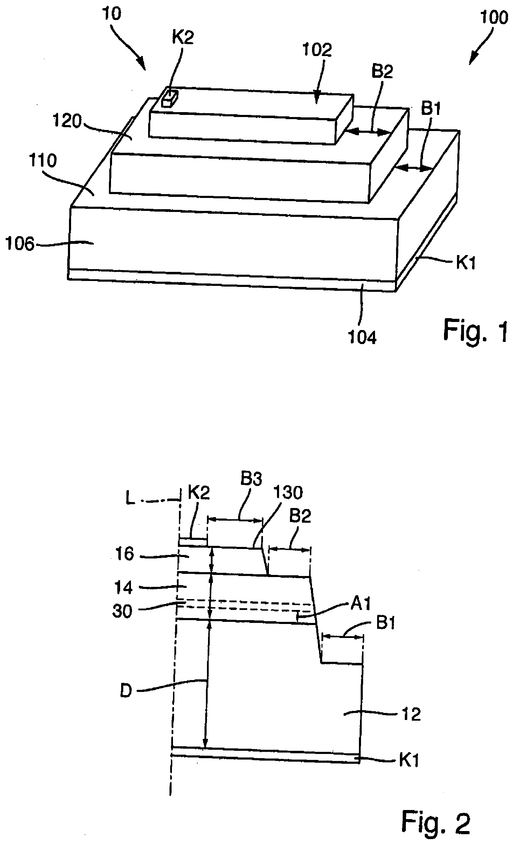

Die Abbildung der Figur 1 zeigt schematisch eine perspektivische Ansicht einer ersten Ausführungsform eines erfindungsgemäßen stapelförmigen III-V-Halbleiterbauelements 10.

Das Halbleiterbauelement 10 weist einen aus mehreren Halbleiterschichten bestehenden Stapel 100 mit einer rechteckigen Oberseite 102, einer rechteckigen Unterseite 104 und einer die Oberseite 102 und die Unterseite 104 verbindenden Seitenfläche 106. Die Unterseite 104 ist größer als die Oberseite 102. Die Seitenfläche 106 besteht aus vier Treppenförmigen Flächen, so dass sich im Bereich der Seitenfläche 106 ein erster umlaufender absatzförmiger Rand 110 mit einer ersten Breite 120 B1 und ein zweiter umlaufender absatzförmiger Rand mit einer zweiten Breite B2 ausbilden.

Die Unterseite 104 des Stapels 100 ist vollständig von einer ersten Kontaktschicht K1 bedeckt. Eine zweite Kontaktschicht K2 ist auf der Oberseite 102 des Halbleiterbauelements 10 angeordnet.

Eine erste Ausführungsform der Schichtenfolge der Halbleiterschichten des Stapels 100 des Halbleiterbauelements 10 ist in der Abbildung der Figur 2 dargestellt.

Der Stapel 100 weist entlang einer Längsachse L einen schichtförmigen p⁺-Bereich 12 mit einer Dotierstoffkonzentration von 5•10¹⁸-5•10²⁰ N/cm³, eine n⁻-Schicht mit einer Dotierstoffkonzentration von 10¹²-10¹⁷ N/cm³ und einen schichtförmigen n⁺-Bereich mit einer Dotierstoffkonzentration von mindestens 10¹⁹ N/cm³ auf, wobei jede Schicht eine Unterseite und eine Oberseite aufweist.

Die p⁺-Schicht 12 ist als Substrat mit einer Schichtdicke D1 ausgebildet, wobei die Unterseite der p⁺-Schicht 12 die Unterseite des Stapels 100 ausbildet. Ein erster Teil der Oberseite der p⁺-Schicht 12 bildet den umlaufenden ersten Rand 110 mit der Breite B1 aus. Auf einem zweiten Teil der Oberseite der p⁺-Schicht 12 ist die Unterseite der n⁻-Schicht 14 angeordnet. Die n⁻-Schicht 14 weist eine Schichtdicke D2 auf. Ein Teil der Oberseite der n⁻-Schicht bildet den umlaufenden zweiten Rand 130 mit einer Breite B2 aus. Auf einem zweiten Teil der Oberseite der n⁻-Schicht 14 ist die Unterseite der n⁺-Schicht 16 angeordnet. Die n⁺-Schicht 16 weist eine Schichtdicke D3 auf. Die Oberseite der n⁺-Schicht 16 bildet die Oberseite des Stapels 100 aus.

Die Unterseite des Stapels 100 ist vollständig von der ersten Kontaktschicht K1 bedeckt. Die zweite Kontaktschicht K2 ist flächig auf einem zentralen Bereich der Oberseite des Stapels 100 ausgebildet, so dass die Oberseite des Stapels 100, also hier die n⁺-Schicht 16, einen dritten umlaufenden, absatzförmigen Rand 130 mit einer Breite B3 ausbildet.

Alle Schichten 12, 14 und 16 sind monolithisch ausgebildet und umfassen eine GaAs-Verbindung oder bestehen aus einer GaAs-Verbindung.

Optional und daher gestrichelt eingezeichnet, weist der Stapel 100 eine Defektschicht 30 mit einer Schichtdicke D4 auf, wobei die Defektschicht innerhalb der n⁻-Schicht 14 angeordnet ist und zu der Unterseite der n⁻-Schicht 14 bzw. der Oberseite der p⁺-Schicht 12 einen Abstand A1 aufweist.

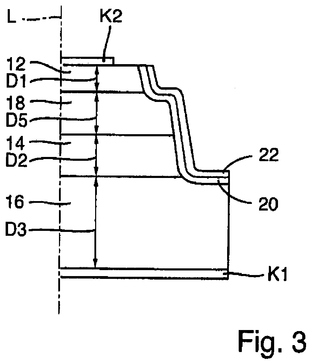

In der Abbildung der Figur 3 ist eine weitere Ausführungsform einer erfindungsgemäßen Schichtfolge des III-V-Halbleiterbauelements dargestellt. Im Folgenden werden nur die Unterschiede zu der Abbildung der Figur 2 erläutert.

Die n⁺-Schicht 16 ist als Substratschicht ausgebildet, gefolgt von der n⁻-Schicht 14, einer p- oder n-dotierten Zwischenschicht 18 mit einer Schichtdicke D5 und der p⁺-Schicht 12.

Durch Implantation ist ein an die Seitenfläche angrenzender Bereich des Stapels 100 von dem ersten umlaufenden Rand 110 bis zu einem an die Oberseite des Stapels 100 angrenzenden Kante isolierend ausgebildet und bildet eine erste Isolationsschicht 20 aus.

Eine zweite Isolationsschicht 22, z.B. eine Oxidschicht oder eine Kombination aus einer Oxidschicht und einer Nitridschicht, ist mittels chemischer Gasphasenabscheidung auf die Seitenflächen im Bereich von dem ersten umlaufenden Rand 110 bis zu einer an die Oberseite des Stapels 100 angrenzenden Kante aufgebracht. Dabei kann sich die Isolationsschicht 22 bis zur Oberfläche 102 erstrecken

## Patentansprüche

1. Stapelförmiges III-V-Halbleiterbauelement (10) aufweisend
- einen Stapel (100) mit einer Oberseite (102), einer Unterseite (104), einer die Oberseite (102) und die Unterseite (104) verbindenden Seitenfläche (106) und einer durch die Oberseite (102) und die Unterseite (104) verlaufenden Längsachse (L), wobei
- der Stapel (100) einen p⁺-Bereich (12) mit einer Oberseite, einer Unterseite und einer Dotierstoffkonzentration von 5•10¹⁸-5•10²⁰ N/cm³ aufweist,
- der Stapel (100) eine n⁻-Schicht (14) mit einer Oberseite und einer Unterseite, einer Dotierstoffkonzentration von 10¹²-10¹⁷ N/cm³ und einer Schichtdicke (D2) von 10 - 300 µm aufweist,
- der Stapel (100) einen n⁺-Bereich (16) mit einer Oberseite, einer Unterseite und einer Dotierstoffkonzentration von mindestens 10¹⁹ N/cm³ aufweist,
- der p⁺-Bereich (12), die n⁻-Schicht (14) und der n⁺-Bereich (16) jeweils monolithisch ausgebildet sind, jeweils eine GaAs-Verbindung umfassen oder jeweils aus einer GaAs-Verbindung bestehen und entlang der Längsachse (L) des Stapels (100) so aufeinander folgen, dass die n⁻-Schicht (14) zwischen dem p⁺-Bereich (12) und dem n⁺-Bereich (16) liegt und
- der n⁺-Bereich (16) oder der p⁺-Bereich (12) als Substratschicht ausgebildet ist, wobei
- der Stapel (100) im Bereich der Seitenfläche (106) einen ersten umlaufenden, absatzförmigen Rand (110) und einen zweiten umlaufenden, absatzförmigen Rand (120) aufweist,
- der erste Rand (110) von der Substratschicht gebildet wird,
- der zweite Rand (120) von der n⁻-Schicht (14) oder von einer zwischen der n⁻
- Schicht (14) und dem p⁺-Bereich (12) angeordneten Zwischenschicht (18) gebildet wird und
- der erste umlaufende Rand (110) und der zweite umlaufende Rand (120) jeweils eine Breite (B1, B2) von mindestens 10 µm aufweisen,
- so dass die Seitenfläche des III-V-Halbleiterbauelements (10) stufenförmig ausgebildet ist.

2. Stapelförmiges III-V-Halbleiterbauelement (10) nach Anspruch 1, **dadurch gekennzeichnet, dass** zumindest entlang eines Teils der Seitenflächen (106) des Stapels (100) in dem Stapel (100) eine durch Implantation erzeugte erste Isolationsschicht (20) ausgebildet ist.

3. Stapelförmiges III-V-Halbleiterbauelement (10) nach Anspruch 2, **dadurch gekennzeichnet, dass** sich zumindest entlang eines Teils der Seitenfläche (106) des Stapels (100) eine zweite Isolationsschicht (22) erstreckt.

4. Stapelförmiges III-V-Halbleiterbauelement (10) nach einem der vorangegangenen Ansprüche, **dadurch gekennzeichnet, dass** das Halbleiterbauelement (10) eine erste Kontaktschicht (K1) und eine zweite Kontaktschicht (K2) umfasst, wobei die zweite Kontaktschicht (K2) die Oberseite (102) des Stapels (100) teilweise überdeckt und die Oberseite (102) des Stapels (100) einen dritten umlaufenden Rand (130) mit einer Breite (B3) von mindestens 10 µm um die zweite Kontaktschicht (K2) herum ausbildet.

5. Stapelförmiges III-V-Halbleiterbauelement (10) nach einem der vorangegangenen Ansprüche, **dadurch gekennzeichnet, dass**
- der p⁺-Bereich (12) und der n⁺-Bereich (16) schichtförmig ausgebildet sind,
- der schichtförmige n⁺-Bereich (16) und der schichtförmige p⁺-Bereich (12) jeweils stoffschlüssig mit der n⁻-Schicht (14) verbunden sind,
- der schichtförmige n⁺-Bereich (16) eine Schichtdicke (D3) von 50 - 675 µm aufweist,
- der schichtförmige p⁺-Bereich eine Schichtdicke (D1) größer 2 µm aufweist und
- das stapelförmige III-V-Halbleiterbauelement (10) eine erste Defektschicht (30) mit einer Schichtdicke (D4) zwischen 0,5 µm und 50 µm aufweist,
- wobei die Defektschicht (30) innerhalb der n⁻-Schicht (14) angeordnet ist und eine Defektkonzentration in einem Bereich zwischen 1•10¹³ N/cm³ und 5•10¹⁶ N/cm³ aufweist.

6. Stapelförmiges III-V-Halbleiterbauelement (10) nach Anspruch 5, **dadurch gekennzeichnet, dass** ein Abstand (A1) der Defektschicht (30) zu einer Grenzfläche zwischen der n⁻-Schicht (14) und dem p⁺-Bereich (12) höchstens die Hälfte der Schichtdicke (D2) der n⁻-Schicht (14) beträgt.

7. Stapelförmiges III-V-Halbleiterbauelement (10) nach einem der Ansprüche 1 bis 4, **dadurch gekennzeichnet, dass**
- der p⁺-Bereich (12) und der n⁺-Bereich (16) schichtförmig ausgebildet sind,
- der schichtförmige n⁺-Bereich (16) stoffschlüssig mit der n⁻-Schicht (14) verbunden ist und
- zwischen der n⁻-Schicht (14) und der p⁺-Schicht (12) eine dotierte Zwischenschicht (18) mit einer Schichtdicke (D5) von 1-50 µm und einer Dotierstoffkonzentration von 10¹²-10¹⁷ cm⁻³ angeordnet ist,
- wobei die Zwischenschicht (18) mit der n⁻-Schicht (14) und mit der p⁺-Schicht (18) stoffschlüssig verbunden ist.

8. III-V-Halbleiterdiode (10) nach einem der Ansprüche 1 bis 7, **dadurch gekennzeichnet, dass** die III-V-Halbleiterdiode (10) monolithisch ausgebildet ist oder einen Halbleiterbond aufweist.

9. III-V-Halbleiterdiode (10) nach Anspruch 8, **dadurch gekennzeichnet, dass** der Halbleiterbond zwischen der p⁻-Schicht (18) und der n⁻-Schicht (14) ausgebildet ist.

## Claims

1. Stack-shaped III-V semiconductor component (10) comprising
- a stack (100) with an upper side (102), a lower side (104), a side surface (106) connecting the upper side (102) and the lower side (104) and a longitudinal axis (L) extending through the upper side (102) and the lower side (104), wherein
- the stack (100) has a p⁺ region (12) with an upper side, a lower side and a doping substance concentration of 5·10¹⁸ - 5·10²⁰ N/cm³,
- the stack (100) has an n⁻ layer (14) with an upper side, a lower side, a doping substance concentration of 10¹² - 10¹⁷ N/cm³ and a layer thickness (D2) of 10 - 300 µm,
- the stack (100) has an n⁺ region (16) with an upper side, a lower side and a doping substance concentration of at least 10¹⁹ N/cm³,
- the p⁺ region (12), the n⁻ layer (14) and the n⁺ region (16) are respectively of monolithic construction, each comprise a GaAs compound or each consist of a GaAs compound and so follow one another along the longitudinal axis (L) of the stack (100) that the n⁻ layer (14) lies between the p⁺ region (12) and the n⁺ region (16), and
- the n⁺ region (16) or the p⁺ region (12) is formed as a substrate layer, wherein
- the stack (100) has in the region of the side surface (106) a first encircling step-shaped edge (110) and a second encircling step-shaped edge (120),
- the first edge (110) is formed by the substrate layer,
- the second edge (120) is formed by the n⁻ layer (14) or by an intermediate layer (18) arranged between the n⁻ layer (14) and the p⁺ region (12), and
- the first encircling edge (110) and the second encircling edge (120) each have a width (B1, B2) of at least 10 µm
- so that the side surface of the III-V semiconductor component (10) is formed to be step-shaped.

2. Stack-shaped III-V semiconductor component (10) according to claim 1, **characterised in that** a first insulating layer (20) produced by implantation is formed in the stack (100) at least along a part of the side surfaces (106) of the stack (100).

3. Stack-shaped III-V semiconductor component (10) according to claim 2, **characterised in that** a second insulating layer (22) extends at least along a part of the side surface (106) of the stack (100).

4. Stack-shaped III-V semiconductor component (10) according to any one of the preceding claims, **characterised in that** the semiconductor component (10) comprises a first contact layer (K1) and a second contact layer (K2), wherein the second contact layer (K2) partly covers the upper side (102) of the stack (100) and the upper side (102) of the stack (100) forms a third encircling edge (130) with a width (B3) of at least 10 µm around the second contact layer (K2).

5. Stack-shaped III-V semiconductor component (10) according to any one of the preceding claims, **characterised in that**
- the p⁺ region (12) and the n⁺ region (16) are of layer-shaped construction,
- the layer-shaped n⁺ region (16) and the layer-shaped p⁺ region (12) are each connected with n⁻ layer (14) by material couple,
- the layer-shaped n⁺ region (16) has a layer thickness (D3) of 50 - 675 µm,
- the layer-shaped p⁺ region has a layer thickness (D1) greater than 2 µm and
- the stack-shaped III-V semiconductor component (10) comprises a first defect layer (30) with a layer thickness (D4) between 0.5 µm and 50 µm,
- wherein the defect layer (30) is arranged within the n⁻ layer (14) and has a defect concentration in a range between 1·10¹³ N/cm³ and 5·10¹⁶ N/cm³.

6. Stack-shaped III-V semiconductor component (10) according to claim 5, **characterised in that** a spacing (A1) of the defect layer (30) from a boundary surface between the n⁻ layer (14) and the p⁺ region (12) is at most half the layer thickness (D2) of the n⁻ layer (14).

7. Stack-shaped III-V semiconductor component (10) according to any one of claims 1 to 4, **characterised in that**
- the p⁺ region (12) and the n⁺ region (16) are of layer-shaped construction,
- the layer-shaped n⁺ region (16) is connected with the n⁻ layer (14) by material couple and
- a doped intermediate layer (18) with a layer thickness (D5) of 1 - 50 µm and a doping substance concentration of 10¹² - 10¹⁷ cm⁻³ is arranged between the n⁻ layer (14) and the p⁺ layer (12),
- wherein the intermediate layer (18) is connected with the n⁻ layer (14) and with the p⁺ layer (18) by material couple.

8. Stack-shaped III-V semiconductor component (10) according to any one of claims 1 to 7, **characterised in that** the III-V semiconductor diode (10) is of monolithic construction or comprises a semiconductor bond.

9. Stack-shaped III-V semiconductor component (10) according to claim 8, **characterised in that** the semiconductor bond is formed between the p⁻ layer (18) and the n⁻ layer (14).

## Revendications

1. Composant à semi-conducteur III-V sous forme d'empilement (10), comprenant:
- un empilement (100) qui présente un côté supérieur (102), un côté inférieur (104), une surface latérale (106) qui relie le côté supérieur (102) au côté inférieur (104) et un axe longitudinal (L) qui s'étend à travers le côté supérieur (102) et le côté inférieur (104), dans lequel
- l'empilement (100) comprend une région p⁺ (12) qui présente un côté supérieur, un côté inférieur et une concentration en substances dopantes comprise entre 5^{∗}10¹⁸ N/cm³ et 5^{∗}10²⁰ N/cm³,
- l'empilement (100) comprend une couche n⁻ (14) qui présente un côté supérieur et un côté inférieur, une concentration en substances dopantes comprise entre 10¹² N/cm³ et 10¹⁷ N/cm³ et une épaisseur de couche (D2) comprise entre 10 µm et 300 µm,
- l'empilement (100) comprend une région n⁺ (16) qui présente un côté supérieur, un côté inférieur et une concentration en substances dopantes d'au moins 10¹⁹ N/cm³,
- la région p⁺ (12), la couche n⁻ (14) et la région n⁺ (16) se présentent respectivement sous forme monolithique, comprennent respectivement un composé GaAs ou sont constituées respectivement d'un composé GaAs et se suivent le long de l'axe longitudinal (L) de l'empilement (100), de telle manière que la couche n⁻ (14) soit située entre la région p⁺ (12) et la région n⁺ (16), et
- la région n⁺ (16) ou la région p⁺ (12) est réalisée comme une couche de substrat, dans lequel
- l'empilement (100) présente dans la région de la surface latérale (106) un premier bord périphérique sous forme d'épaulement (110) et un deuxième bord périphérique sous forme d'épaulement (120),
- le premier bord (110) est formé par la couche de substrat,
- le deuxième bord (120) est formé par la couche n⁻ (14) ou par une couche intermédiaire (18) qui est disposée entre la couche n⁻ (14) et la région p⁺ (12), et
- le premier bord périphérique (110) et le deuxième bord périphérique (120) présentent respectivement une largeur (B1, B2) qui est égale à au moins 10 µm,
- de telle manière que la surface latérale du composant à semi-conducteur III-V (10) soit réalisée sous forme étagée.

2. Composant à semi-conducteur III-V sous forme d'empilement (10) selon la revendication 1, **caractérisé en ce qu'**une première couche d'isolation (20) produite par implantation est formée au moins le long d'une partie des surfaces latérales (106) de l'empilement (100) dans l'empilement (100).

3. Composant à semi-conducteur III-V sous forme d'empilement (10) selon la revendication 2, **caractérisé en ce qu'**une deuxième couche d'isolation (22) s'étend au moins le long d'une partie de la surface latérale (106) de l'empilement (100).

4. Composant à semi-conducteur III-V sous forme d'empilement (10) selon l'une quelconque des revendications précédentes, **caractérisé en ce que** le composant à semi-conducteur (10) comprend une première couche de contact (K1) et une seconde couche de contact (K2), dans lequel la seconde couche de contact (K2) recouvre en partie le côté supérieur (102) de l'empilement (100) et le côté supérieur (102) de l'empilement (100) forme un troisième bord périphérique (130) qui présente une largeur (B3) égale à au moins 10 µm autour de la seconde couche de contact (K2).

5. Composant à semi-conducteur III-V sous forme d'empilement (10) selon l'une quelconque des revendications précédentes, **caractérisé en ce que**:
- la région p⁺ (12) et la région n⁺ (16) sont réalisées sous forme de couche,
- la région n⁺ en forme de couche (16) et la région p⁺ en forme de couche (12) sont à chaque fois assemblées matériellement à la couche n⁻ (14),
- la région n⁺ en forme de couche (16) présente une épaisseur de couche (D3) comprise entre 50 µm et 675 µm,
- la région p⁺ en forme de couche présente une épaisseur de couche (D1) supérieure à 2 µm, et
- le composant à semi-conducteur III-V sous forme d'empilement (10) comprend une première couche de défauts (30) qui présente une épaisseur de couche (D4) comprise entre 0,5 µm et 50 µm,
- dans lequel la couche de défauts (30) est disposée à l'intérieur de la couche n⁻ (14) et présente une concentration de défauts située dans une plage comprise entre 1^{∗}10¹³ N/cm³ et 5^{∗}10¹⁶ N/cm³.

6. Composant à semi-conducteur III-V sous forme d'empilement (10) selon la revendication 5, **caractérisé en ce qu'**une distance (A1) de la couche de défauts (30) à une surface limite entre la couche n⁻ (14) et la région p⁺ (12) est au maximum égale à la moitié de l'épaisseur de couche (D2) de la couche n⁻ (14).

7. Composant à semi-conducteur III-V sous forme d'empilement (10) selon l'une quelconque des revendications 1 à 4, **caractérisé en ce que**:
- la région p⁺ (12) et la région n⁺ (16) sont réalisées en forme de couche,
- la région n⁺ en forme de couche (16) est assemblée matériellement à la couche n⁻ (14), et
- une couche intermédiaire dopée (18) qui présente une épaisseur de couche (D5) comprise entre 1 µm et 50 µm et une concentration en substances dopantes comprise entre 10¹² N/cm³ et 10¹⁷ N/cm³ est disposée entre la couche n⁻ (14) et la couche p⁺ (12),
- dans lequel la couche intermédiaire (18) est assemblée matériellement à la couche n⁻ (14) et à la couche p⁺ (18).

8. Diode à semi-conducteur III-V (10) selon l'une quelconque des revendications 1 à 7, **caractérisée en ce que** la diode à semi-conducteur III-V (10) est réalisée sous forme monolithique ou présente une jonction de semi-conducteurs.

9. Diode à semi-conducteur III-V (10) selon la revendication 8, **caractérisée en ce que** la jonction de semi-conducteurs est réalisée entre la couche p⁻ (18) et la couche n⁻ (14).
